(19) Europäisches Patentamt
European Patent Office
Office européen des brevets

(11) EP 0 860 019 B1

(12) EUROPÄISCHE PATENTSCHRIFT

(45) Veröffentlichungstag und Bekanntmachung des Hinweises auf die Patenterteilung:
08.12.1999 Patentblatt 1999/49

(51) Int Cl.⁶: **H01J 37/06**, H01J 3/02

(21) Anmeldenummer: 96938045.0

(22) Anmeldetag: 02.11.1996

(86) Internationale Anmeldenummer:
PCT/EP96/04763

(87) Internationale Veröffentlichungsnummer:
WO 97/17715 (15.05.1997 Gazette 1997/21)

(54) **GEPULSTE ELEKTRONENSTRAHLQUELLE UND DEREN VERWENDUNG**

PULSED ELECTRON BEAM SOURCE AND USE THEREOF

SOURCE DE FAISCEAU ELECTRONIQUE PULSEE ET UTILISATION DE LADITE SOURCE

(84) Benannte Vertragsstaaten:
AT BE CH DE FR GB IT LI

(30) Priorität: 08.11.1995 DE 19541510

(43) Veröffentlichungstag der Anmeldung:
26.08.1998 Patentblatt 1998/35

(73) Patentinhaber: Forschungszentrum Karlsruhe GmbH
76133 Karlsruhe (DE)

(72) Erfinder:
• SCHULTHEISS, Christoph
D-76327 Berghausen (DE)
• ENGELKO, Vladimir
St. Petersburg, 189631 (RU)
• KRAFFT, Gerd
D-76149 Karlsruhe (DE)
• SCHUMACHER, Gustav
D-76149 Karlsruhe (DE)
• MÜLLER, Georg
D-76135 Karlsruhe (DE)

(56) Entgegenhaltungen:
• SOVIET PHYSICS TECHNICAL PHYSICS, Bd. 26, Nr. 7, Juli 1981, NEW YORK US, Seiten 847-853, XP002025145 V.A. BURTSEV ET AL.: "Operation of an electron beam source with an explosive-emission cathode in the frequency mode with a long pulse duration."
• INTERNATIONAL CONFERENCE ON HIGH POWER PARTICALE BEAMS, 1992, Seiten 1935-1941, XP000613714 ENGELKO V I ET AL: "PULSE HEAT TREATMENT OF MATERIAL SURFACE BY HIGH-CURRENT ELECTRON BEAM"
• SOVIET TECHNICAL PHYSICS LETTERS, Bd. 14, Nr. 6, Juni 1988, Seite 488/489 XP000045263 KOVALEV V G ET AL: "INCREASING THE ENERGY OF A MICROSECOND-RANGE HOLLOW RELATIVISTIC ELECTRON BEAM GENERATED BY A MULTITIP EXPLOSIVE-EMISSION CATHODE"

## Beschreibung

Die Erfindung betrifft eine gepulste Elektronenstrahlquelle nach dem Oberbegriff des Patentanspruchs 1 und deren Verwendung.

Aus V.I. Engelko, et al. Pulsed Heat Treatment of Material Surface, 9th Int. Conf. on High Power Particale Beams, Beams 92, p1935 (1992) ist eine Elektronenvakuumdiode mit Multipunkt-Emissionskathode beschrieben, die in der Lage ist 60-180 keV Elektronenstrahlen mit Stromdichten von bis zu 60 A/cm$^2$ mit Pulsdauern von bis zu 40 µs zu liefern.

Aufgabe der Erfindung ist es, eine Elektronenstrahlquelle der e. g. Art derart auszugestalten, daß Pulslängen von 100 µs erreichbar sind und die Pulsform nicht nur rechteckig ist, sondern auch Stufen aufweisen kann.

Gelöst wird diese Aufgabe durch die kennzeichnenden Merkmale des Patentanspruchs 1. Die Unteransprüche beschreiben vorteilhafte Ausgestaltungen der Erfindung. Die Ansprüche 6 und 7 nennen vorteilhafte Verwendungen der Elektronenstrahlquelle.

Die Vorteile der Elektronenstrahlquelle lassen sich wie folgt zusammenfassen:

1. Die zeitliche Stabilität der Entladung ist über die gesamte Pulsdauer von bis zu 100 µs gewährleistet, d. h. es treten bei Pulsdauern über 10 µs keine Kurzschlüsse mehr auf. Diese Tatsache erhöht die Standzeit der Anlage enorm.

2. Die Schuß zu Schuß Reproduzierbarkeit bezüglich der Stromdichte ist mit 10 % um einen Faktor 5 höher als zuvor.

3. Der realisierte Strahlquerschnitt ist mindestens einen Faktor 3 höher, was zur Umsetzung des Verfahrens nach Anspruch 6 sehr vorteilhaft ist.

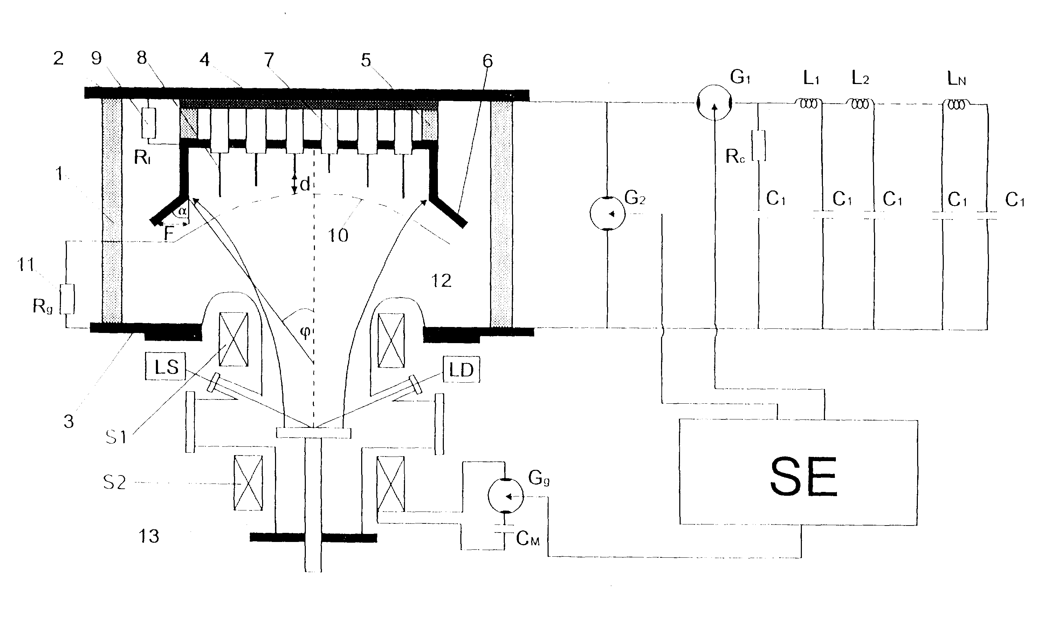

Die Erfindung wird im folgenden anhand eines Ausführungsbeispiels mit Hilfe der Figur näher erläutert. Dabei zeigt die Figur schematisch eine beschaltete Elektronenstrahlquelle.

Die gepulste Elektronenstrahlquelle hat die Form einer sphärischen Vakuumdiode, in der der Elektronenstrahl erzeugt, beschleunigt und auf den Eingang einer ebenfalls gepulsten magnetischen Kompressionseinheit fokussiert wird. Dort wird der Strahl auf die benötigte Stromdichte komprimiert, bevor er auf das Target trifft. Die Spannungsversorgung für die Diode, wie auch die Stromversorgung für die magnetische Kompression wird von Stoßleistungsanlagen geliefert. Eine Kontrolleinheit synchronisiert den Ablauf. Die vorteilhaften Elemente in dieser Anordnung sind zum einen eine potentialmäßig kontrolliert flotierende Schirmelektrode, die drei Aufgaben zu erfüllen hat:

- Schutz der Kathodenwiderstände vor dem rückströmenden Kathodenplasma und den entstehenden Targetdämpfen, die in die Diode gelangen, die Diodenimpedanz verändern und vorzeitig einen Kurzschluß auslösen,

- Kontrolle des Potentials der Schirmplatte zur Vermeidung eines Oberflächenplasmas auf ihr, das in den Beschleunigungsspalt expandiert und einen Kurzschluß auslöst und

- Ausgleich der Randverzerrungen des elektrischen Feldes nach dem Pierceelektrodenprinzip.

Zum anderen enthält die Diode ein Steuergitter mit variablem Widerstand, mit dessen Hilfe die Stromdichte auf dem Target kontrolliert werden kann.

Ein drittes vorteilhaftes Element ist schließlich die Kontrolleinheit, die die Auswirkung der Bestrahlung auf dem Target optisch aufnimmt und den scharfen Abriß der Energieeinkopplung am Ende der Betrahlung einleitet.

In der Figur ist die Gesamtanlage dargestellt. Die Diode ist wie folgt aufgebaut: Sie besteht aus einem Hochspannungsisolator 1, der den Kathodenflansch 2 von dem geerdetem Anodenflansch 3 trennt. Die Elektronen werden in der Multipunkt-Emissionskathode erzeugt. Sie besteht aus einer Kathodengrundplatte 4, einem Isolator 5 und darauf angeordnet der flotierenden Schirmelektrode 6, die am Rand als Pieceelektrode ausgeformt ist. Von der Kathodengrundplatte 4 und durch die Schirmplatte 6 hindurch reichen dicht angeordnet Widerstände Rp 7, an deren Ende sich Feldemmisionsquellen 8 befinden. Die Feldemissionpunkte bilden ein sphärisches Raster. Der Abstand der Feldemissionspunkte 8 untereinander beträgt bis zu 10 mm. Die Emissionspunkte bestehen aus Bündeln von Kohlenstoffasern, mit einem Faserdurchmesser von 10 µm. Die Schirmelektrode 6 ist über einen Widerstand Rl 9 mit der Kathodengrundplatte 2 verbunden. Die Länge des Isolators 5 entspricht etwa der Länge der zylindrischen Widerstände Rp 7. Die Weite der Öffnungen in der Schirmplatte 6, durch die die Widerstände Rp 7 in den Diodenraum reichen sind eng bemessen. Damit wird erfindungsgemäß erreicht, daß die Widerstände Rp 7 in ihrer Gesamtheit von Einflüßen aus dem Diodenraum abgeschirmt werden; andernfalls würden das Kathodenplasma und Targetdämpfe die Funktionalität der Widerstände während des Pulses beinträchtigen und sie schließlich kurzschließen.

Die Widerstände Rp 7 dienen zur Strombegrenzung der einzelnen Feldemissionsquellen 8. Dadurch wird erreicht, daß nicht mehr Elektronen pro Fläche produziert werden, als anschließend raumladungsbegrenzt im elektrischen Feld wegtransportiert werden können. Die Größe der Widerstände Rp wird durch die folgende Beziehung bestimmt:

$$R_p = \frac{9\pi \; Nhd}{S} \left(\frac{m}{2eU_g}\right) 1/2$$

$$R_l \gg \left(\frac{2\pi \; M}{kT_e}\right) 1/2 \; \frac{I_p R_p}{enS}$$

wobei $U_g$ die Diodenspannung zwischen einem Steuergitter 10 und der Kathode ist, N die Anzahl der Emissionspunkte 8, h die mittlere Höhe der Emissionspunkte, S die emittierte Gesamtfläche, $I_p$ der Strom durch einen Einzelpunkt, e und m Ladung und Masse des Elektrons und d der Abstand zwischen den Emissionspunkten 8 und dem Steuergitter 10, n und Te sind die Dichte und Elektronentemperatur des Kathodenplasmas.

Der Widerstand Rl 9 hat zwei Funktionen und ist zum einen erfindungsgemäß so bemessen, daß die Schirmelektrode und das Kathodenplasma im wesentlichen das gleiche Potential besitzen (floating potential). Kommt es nämlich zwischen der Schirmelektrode 6 und dem Kathodenplasma zu einer Berührung, tritt die Plasma-Wand Wechselwirkung auf, in deren Verlauf ein Sekundärplasma entsteht, das in den Beschleunigungsspalt expandiert und die Diode kurzschließt. Das freie Floatieren der Schirmelektrode 6 verhindert diesen Prozess, da die Feldstärke zwischen dem Kathodenplasma und der Oberfläche der Schirmelektrode gering ist. Die zweite Funktion von Rl 9 ist dafür zu sorgen, daß die verbleibende Restladung nach dem Ende des Pulses von der Schirmelektrode 6 wieder abfließen kann. Diese Restladung würde sonst, durch Verminderung des Feldes im Diodenraum, das Zünden der Diode im darauffolgenden Puls stark stören.

Zum Ausgleich der Randverzehrung des elektrischen Feldes wird der geometrische Parameter F der Schirmelektrode 6 in der Figur soll gleich d gewählt und der Winkel a hängt vom optimalen Krümmungsradius der Multipunkt-Emissionskathode ab und bestimmt sich aus der Beziehung $a = 67.5° - \varphi$. Die Größe d sollte etwa 5 mal größer als der Abstand der Emissionspunkte untereinander sein. Das Steuergitter 10 ist aus Temperatur beständigen Material gefertigt und hat ebenfalls sphärische Form. Das Gitter soll eine hohe Transparenz für Elektronen haben. Über einen variablen Widerstand Rg 11 ist es mit dem Erdpotential 3 verbunden.

Die Stoßleistungsanlage besteht aus einer inhomogenen pulsformenden Linie, bestehend aus Kapazität C1 und Induktivitäten L1, L2, ..., Ln, einem Korrekturwiderstand Rc, dem Hochspannungsschalter G1 und dem Kurzschußschalter G2 (Crowbar). Die Größe der Induktivität wird durch die folgende Beziehung bestimmt:

$$L_n = C_l Z^2 \frac{T_n}{N}$$

wobei $Z(t)=U(t)/I(t)$, $U(t)$ ist die Diodengesamtspannung, $I(t)$ ist der Diodengesamtstrom, T die Pulsdauer und N die Gesamtzahl der pulsformenden LC-Glieder ist.

Durch Variation der einzelnen Induktivitäten läßt sich die Pulsform der Stoßleistungsanlage verändern, so daß nach Anspruch 7 über die zeitliche Variation der Elektronenenergie (Eindringtiefe) sich gewünschte Temperaturprofile einstellen lassen.

Die Magnetkompressionseinheit besteht aus mindestens zwei Selenoidspulen S1, S2, der Kapazität $C_M$ und dem Hochspannungsschalter Gg. Die Auslegung der Selenoide und der Kapazität wird numerisch berechnet, so daß das magnetische Feld eine optimale Fokussierung auf das Target bewirkt. Die Form der Anodenelektrode 12 mit der zentralen Öffnung, durch die der Elektronenstrahl die Diode verläßt, ist ebenfalls das Ergebnis einer numerischen Optimierung.

Der Targetraum 13 ist eine Vakuumkammer, die mit dem Anodenflansch 3 verbunden ist. Sie ist mit einem Pumpanschluß versehen und weist eine Zugang zum Targetwechsel auf. Weiterhin enthält sie ein Beobachtungsfenster sowie zwei Fenster für ein optisches Meßsystem zur Überwachung von Phasenübergängen, die sich an einem Wechsel der optischen Reflektivität der Oberfläche bemerkbar machen.

Die Aufgabe der Steuereinheit SE ist es eine Folge von Steuerspannungspulsen an die Schalter G1 bis G3 zu geben, wobei der Schalter G1 die Spannung an die Diode anlegt und G2 sie abschaltet; G3 schaltet den Spulenstrom ein. Das Ausschalten der Diodenspannung durch G2 erfolgt erfindungsgemäß über eine Rückkopplung durch eine optische Messung direkt am Target. Mit Eintritt der Änderung der optischen Reflektivität der Targetoberfläche nach Erreichen des Schmelzpunktes, wird der Energiefluß auf das Target sofort, oder nach einem vom Verfahren her gewünschten zeitlichen Verzug unterbrochen.

Die Anlage arbeitet in der folgenden Weise:

Als erstes gibt die Zentraleinheit einen Zündimpuls an den Schalter G3. Die Speicherkapazität Cm entlädt sich in die Selenoide S1 und S2. Nach einer Zeitspanne, die nötig ist bis der Strom in den Seleoniden den maximalen Wert erreicht hat (etwa 1 Millisekunde), erzeugt die Zentraleinheit einen zweiten Zündpuls, der den Schalter G1 schließt. Nachdem die Hochspannung an dem Diodenbeschleunigungsspalt zwischen der Multipunkt-Emissionskathode und dem zunächst auf Anodenpotential liegendem Gitter anliegt, kommt es zur Anregung einer explosiven Emission von Elektronen am Ende der einzelnen Kohlenstoffaserbündel. Es bildet sich sofort ein weitgehend homogenes Plasma bestehend aus Elektronen und Kohlenstoffionen vor den Emissionspunkten. Die Elektronen werden durch das elektrische Feld, das zwischen Kathode und Gitter anliegt extrahiert. Der Teil $(1-k)*1$ des Elektronenstroms, wobei I der Gesamtelektronenstrom ist, wird vom Gitter mit der Transparenz k absorbiert und fließt über den Widerstand Rg ab. Die Folge ist ein Spannungsabfall an Rg der Höhe (1-k)∗1∗ Rg. Daher teilt sich die Stoßspannung zwischen Kathode-Gitter und Gitter-Anode. Der Wert des Elektronenstroms I bestimmt sich aus der Child-Langmuir Gleichung für das Kathoden-Gitterpotential:

$$I = \frac{4}{9} \left(\frac{2e}{m}\right) 1/2 \frac{[U - (1 - k)IR_g]^{3/2} \sin^2(\theta/2)}{\alpha^2 (r_f/r_g)}$$

wobei U die Diodenspannung ist, rg der Radius des Gitterkreises und $r_f$ der Fokusradius

$$\alpha^2 \left(\frac{r_f}{r_g}\right) = \ln \left(\frac{r_f}{r_g}\right) - 0.3 \ln^2 \left(\frac{r_f}{r_g}\right) + ...$$

Wie man aus der Formel ersehen kann, hängt die Höhe des Elektronenstroms jetzt vom Widerstand Rg ab.

Die Stabilität und Homogenität des Elektronenstrahlstroms während der gesamten Pulslänge von einigen 10 Mikrosekunden wird auf folgende Weise erreicht:

Um einen zeitstabilen Elektronenstrom zu bekommen, darf das Elektronenplasma nicht in den Kathoden-Gitter Spalt expandieren. Der kinetische Druck des Elektronenplasmas der Kathode muß kleiner als der Druck des elektrischen Feldes im Kathoden-Gitter Spalt sein. Diese Bedingung wird durch den Einsatz der Multipunkt-Emissionkathode erreicht, weil die Quellfläche für Elektronenemission sich auf die kleine Fläche der Emissionspunkte beschränkt. Darüber hinaus rekombinieren die Kohlenstoffionen einen Teil der Elektronen im Bereich der flotierenden Schirmelektrode 6, wohin die Ionen driften. Damit erreicht man eine niedrige Elektronendichte bzw. einen niedrigen Plasmadruck. Die Gefahr einer zusätzlichen Elektronenemission, etwa durch explosive Emission am Oberflächenrand der flotierenden Schirmelektrode 6 begegnet man durch Beschränkung der maximalen Feldstärke im Kathoden-Gitter Spalt auf Werte um $10^7$ V/m. Ein Kurschluß der Kathodenwiderstände durch das rückströmende Kathodenplasma wird wie schon beschrieben erfindungsgemäß durch Beschaltung und Auslegung der Schirmelektrode 6 gebannt.

Durch die o. g. Vorkehrungen ist eine stabile Betriebsweise des Elektronenbeschleunigers bis zu maximal 100 µs möglich. Eine Verkürzung der Bestrahlungszeit, etwa nach der optischen Registrierung des Aufschmelzens der Probe, wird, wie schon beschrieben, durch das Aktivieren des Schalters G2 durch das Programm der Steuereinheit SE veranlaßt.

Als Anwendung der gepulsten großflächigen Elektronenstrahlquelle wird ein zerstörungsfreies thermisches Verfahren vorgeschlagen. Das die schockartige Erhitzung einer dünnen Oberflächenschicht von einigen 10 µm Tiefe auf eine Temperatur beinhaltet, bei der die Oberfläche nicht zerstört wird, aber alle gewünschten Phasenumwandlungen, Mischungen von Atomen ect. stattfinden. Nach dieser Zeit, die zwischen 1 bis 100 µs Dauer liegt, kühlt die Schicht, durch Wärmeleitung ins Innere, so schnell ab, daß die gewünschte Phase bzw. die Mischung, so wie sie sich gebildet hat, einfriert.

In der Literatur sind bereits eine Reihe von Anlagen beschrieben, in denen versucht wird, durch kurzzeitige Einwirkung von gerichteter Energie die Oberfläche einer Probe zu härten. Zu nennen sind gepulste Laser. Die Eindringtiefe der Laserenergie in die Materialoberfläche ist zu vernachlässigen. Sie beträgt nur 20 nm. Hinzu kommt, daß die Einkopplung der Laserenergie nur über ein Ablationsplasma effektiv ist und somit die Oberfläche angegriffen wird. Die höchste Temperatur wird an der Oberfläche erreicht und sinkt mit zunehmender Tiefe in das Material schnell ab. Die Folge ist eine geringe Härtungstiefe.

Es wird auch weltweit versucht gepulste Plasmaanlagen zur Härtung von Oberflächen einzusetzen. Heißes und dichtes Wasserstoffplasma mit einer Transversalenergie von einigen 100 eV bis fast 1 keV trifft auf die Oberfläche. Die Wärmeeinkopplung ist im allgemeinen mit einer starken Erosion verbunden. Inhomogenitäten in der Leistungsdichte sind nur schwer zu beherrschen. Da die Plasmaquellen keine Abschaltcharakteristik haben fließt nach der ersten hochenergetischen Plasmafront niederenergetisches Plasma hinterher, das die Oberfläche an einer schnellen Abkühlung hindert und, da meist Elektrodenmaterial dem Plasma beigemischt ist, wird die Oberfläche kontaminiert. Versuche das nachfließende Plasma mit gepulsten inhomogenen Magnetfeldern abzuschneiden sind aufwendig und begrenzt effektiv, da rekombinierte Atome die Magnetsperre passieren.

In der Literatur findet man auch gepulste Elektronenstrahlenquellen beschrieben, die in der Lage sind Oberflächen kurzzeitig aufzuschmelzen. Es handelt sich dabei um gepulste Niederdruckgasentladungen. Die Pulsdauern sind hierbei weit unterhalb einer Mikrosekunde. Die Energieeinkopplung gegen Ende des Pulses verläuft flach. In der Regel besteht keine Impedanzanpassung zwischen dem Energiespeicher (Kondensatorbank) und der Elektronenquelle, so daß nach dem Hauptpuls gedämpfte Oszillationen auftreten, die Energie zur Oberfläche nachfließen lassen und die Abkühlung verzögern.

Jedoch haben Elektronen den Vorteil der hohen Reichweite in ein Material im Vergleich mit Ionen und Laserenergie. So dringt ein 100 keV-Elektron etwa 20 µm tief in Stahl ein. Solche Tiefen sind für die Oberflächenvergütung von wirklichem Interesse, denn nur eine Vergütung mit ausreichender Tiefenwirkung verspricht eine lang andauernde Wirkung.

Das Verfahren zur thermischen Behandlung von Oberflächen mit dem Ziel die Oberflächenstruktur zu modifizieren besteht zunächst aus der kontrollierten Einkopplung von Prozessenergie in eine Oberflächenschicht von 5 - 50 µm Tiefe über eine Zeitdauer von 1 - 100 µs mit einer Leistungsdichte von 1 - 10 MW/cm$^2$, die zum Aufschmelzen, oder zur Aufbrechung interatomarer bzw. intermolekularer Bindungen und zu ungewöhnlichen Mischungen von Elementen und metastabilen Phasen führt, die sonst nur bei den eingestellten hohen Temperaturen existieren können. Nur der Elektronenstrahl garantiert eine nahezu isotherme Aufheizung über die erforderliche Schichtdicke von einige 10 µm.

Dann folgt die Abschreckphase. Sie ist von zentraler Bedeutung in diesem Verfahren. Die Energieeinkopplung wird innerhalb sehr kurzer Zeit (< 1 µs) unterbrochen. Die Wärme in der Schicht fließt in das Material ab. Abhängig von der spezifischen Wärmeleitfähigkeit des Materials und der Tiefe der Schicht erfolgt das mehr oder weniger schnell. Durch die Vorgabe, daß zum Einfrieren der nur bei hohen Temperaturen auftretenden Strukturzustände bzw., daß zur Vermeidung ungewünschter kristalliner Reorganisationen, eine Abkühlrate in der Größenordnung $> 10^6$ K/s erreicht werden muß, ergibt sich eine Forderung an die Prozeßparameter, Wie Pulsdauer, Elektronenenergie und Stromdichte.

Mit der Kenntnis der Materialdaten eines Körpers, dessen Oberfläche modifiziert werden soll, wie:

- spezifischen Wärmeleitfähigkeit
- Wärmekapazität
- Phasendiagramm mit gewünschtem Strukturzustand
- Abkühlrate in K/s zum Einfrieren des Strukturzustandes
- Dichte

ermittelt man über die Wärmeleitungsgleichung die maximale Schichtdicke, die aufgeheizt werden kann.

Wie schon erwähnt, kann nur der Elektronenstrahl die isotherme Aufheizung der Schicht leisten. Mit der Ermittlung der maximal aufheizbaren Schichtdicke bedeutet das:

- Wahl der Beschleunigungsspannung, so daß Elektronenreichweite gleich Schichtdicke ist,
- Stromdichte so wählen, daß Schicht gewünschte Temperatur erreicht,
- Unterbrechung der Energiezufuhr derart kurzzeitig, daß Abkühlrate sich einstellt.

Für gängig zu bearbeitende Materialien reichen für dieses Verfahren Elektronenstrahlenergien zwischen 50 und 150 keV aus. Die Stromdichte liegt bei Werten bis 50 A/cm$^2$.

Wollte man Ionenstrahlen dazu verwenden, müßte man 10-fach höhere Beschleunigungsenergien wählen, ganz abgesehen davon, daß es keinen Ionenbeschleuniger gibt der über die gefordeten Zeiten Stromdichten in dieser Höhe liefern kann. Hinzu kommen die Kontamination der Schicht mit der Ionensorte und der Impulsübertrag durch die Ionen, der zwangsläufig die Materialoberfläche über den Sputtereffekt beschädigt.

Das Einsatzspektrum dieses Verfahrens beschränkt sich nicht nur auf die Strukturänderung der Oberfläche von Metallen, Legierungen, intermetallischen Legierungen und anorganischen Verbindungen, sondern kann auch zur Verfestigung bzw. zum Einschmelzen von vorher aufgebrachten Schichten von Metallen, Legierungen, intermetallischen Legierungen, organischen- und anorganischen Verbindungen auf beliebigen Trägermaterialien verwendet werden. So kann man auch durch Annealing vorher implantierte Ionen, die zunächst Zwischengitterplätze einnehmen gezielt auf Gitterplätze bringen. Die hohe Abkühlrate ermöglicht auch Oberflächenstrukturen, die wegen der extremen Nichtgleichgewichtsphysik Zustände wiederspiegeln, die sonst nicht zu realisieren sind. So können die Schichten Strukturen zwischen amorph und nanokristallin aufweisen, oder metastabile Phasen darstellen. So können konventionell nicht härtbare Werkstoffe mit einer härteren Oberflächenschicht versehen werden.

Als Anwendungsbeispiel sollen Oberflächenhärteversuche an konventionellen Hydrostößeln eines Saugdieselmotors vorgestellt werden. Die Teller der Hydrostößel wurden an der Oberfläche mit einem Elektronenstrahlpuls mit folgenden Parametern behandelt: Leistungsdichte 2 MW/cm$^2$, Elektronenenergie 140 keV und Pulsdauer 30 µs. Nach der Bestrahlung werden die Hydrostößel in einem 46 kW 4Zylinder Saugdieselmotor auf das Langzeitverschleißverhalten (RTM-Messung) hin untersucht. Detektiert wurde hierbei sowohl der Verschleiß an dem unbehandeltem Laufpartner (Nockenwelle) als auch am behandeltem Hydrostößel. Es zeigte sich, daß der Verschleiß an dem behandeltem Hydrostößel im Vergleich zum unbehaldeltem Hydrostößel um einen Faktor 5 geringer ist und, daß selbt der Verschleiß von unbehaldelten Nockenwellen, die gegen behandelte Hydrostößel laufen um einen Faktor 2.5 geringer ausfällt, als bei unbehandelten Nockenwellen und Hydrostößeln.

Als Ursache wird neben der Zunahme der Härte, die von 700 HV nach der Bestrahlung auf 1800 HV zunimmt, auch das, durch den Umschmelzprozeß sich ergebende, feinkristalline Gefüge der behandelten Oberflächenschicht vermutet.

Die Elektronenquelle kann wie folgt eingesetzt werden:

i) Verändern der Oberflächen von Metallen, Legierung, intermetallischer Legierungen, organischen- und anorganischen Verbindungen,

ii) zur Verfestigung bzw. zum Einschmelzen von vorher aufgebrachten Schichten von Metallen, Legierungen, intermetallischer Legierungen, organischen- und anorganischen Verbindungen auf beliebigem Trägermaterial, und zur Legierungsbildung mit den metalischen Schichten,

iii) zum Zwecke des Annealings von vorher implantierten Atomen in einer Materialoberfläche,

iv) um Oberflächenstrukturen zu erhalten, die zwischen amorph und nano-krislallin einzuordnen sind, oder metastabile Phasen haben sollen,

v) zur Glättung rauher Oberflächen, wobei

i) gerichtete gepulste Energie in Form eines homogenen gepulsten Elektronenstrahls mit einem Durchmesser von > 6cm, einer Energie von 50 bis 200 keV und einer Stromdichte bis zu 50 A/cm$^2$ auf die Oberfläche trifft und

ii) mit einer der Elektronenenergie entsprechenden Reichweite in das Material eindringt, so daß eine Schicht von bis zu einigen 10 mm Tiefe im Material erfaßt wird und

iii) während einer Zeitdauer von 1-100 μs die Schicht auf eine solche Temperatur aufgeheizt wird, daß noch keine Oberflächenerosion auftritt, jedoch in dieser Zeitspanne Oberflächenprozesse ablaufen können mit der Folge und dem Ziel, daß:

vi) die Schicht aufschmilzt und interatomare bzw. intermolekulare Bindungen aufgebrochen werden und sich neue Mischungen von Elementen oder metastabile Phasen ausbilden und

v) zum Einfrieren solcher Strukturzustände außerhalb des thermodynamischen Gleichgewichts bzw. zur Vermeidung unerwünschter Reorganisationen, nach der Aufheizphase ein scharfer Abriß der Energieeinkopplung erfolgt, so daß unter der Berücksichtigung der Wärmeleitfähigkeit des Materials und der Dicke der aufgeheizten Schicht, die Wärme mit einer Abkühlrate von mehr als 10$^6$ K/s in das Innere des Materials abfließt.

Bezugszeichenliste:

| 1 | Hochspannungsisolator |
| 2 | Kathodenflansch |
| 3 | Anodenflansch |
| 4 | Kathodengrundplatte |
| 5 | Isolator |
| 6 | Schirmelektrode |
| 7 | Widerstände Rp |
| 8 | Feldemmisionsqellen |
| 9 | Widerstand Rl |
| 10 | Steuergitter |
| 11 | Widerstand Rg |
| 12 | Anodenelektrode |
| 13 | Targetraum |
| S1 | Selenoidspule |
| S2 | Selenoidspule |
| C1 | Kapazitäten |
| C$_M$ | Kapazität |
| Ln | Induktivitäten |

**Patentansprüche**

1. Gepulste Elektronenstrahlquelle nach dem Vakuumdiodenprinzip bestehend aus einer Vakuumdiode mit einer Multipunkt-Emissionskathode mit einer Vielzahl von Emissionspunkten (8), einem Steuergitter, einem Pulsgenerator, einer magnetischen Kompressionsseinheit aus Feldspulen, einem Driftraum, einem Targetraum und einer Synchronisationseinheit, dadurch gekennzeichnet, daß die Kathode in eine Schirmelektrode (6) eingebettet ist, wobei die Schirmelektrode (6) über einen Widerstand (9) mit dem Kathodenflansch (2) verbunden ist, wobei der Widerstand (9) so bemessen ist, daß die Schirmelektrode (6) frei flotieren kann.

2. Gepulste Elektronenstrahlquelle nach Anspruch 1, dadurch gekennzeichnet, daß die Schirmelektrode (6) wie ein Topf ausgeformt ist, an dessen Boden sich Bohrungen befinden durch die bündig, in ihrer Gesamtheit, nur das Ende der zylindrischen Widerstandskörper (7) mit den daran befestigten Emissionspunkten (8) ragen.

3. Gepulste Elektronenstrahlquelle nach Anspruch 1 und 2, dadurch gekennzeichnet, daß die Schirmelektrode (6) an ihrem offenen Rand um einen Winkel α abgeneigt ist, der von dem optimalen Krümmungsradius der Multipunkt-Emissionskathode bestimmt wird.

4. Gepulste Elektronenstrahlquelle nach Anspruch 1 bis 3, dadurch gekennzeichnet, daß die Schirmelektrode (6) an ihrem offenen Rand einen um 2∗F größeren Durchmesser hat als am geschlossenen Rand, wobei F gleich dem Abstand d zwischen dem Steuergitter und den Emissionspunkten ist.

5. Verwendung der gepulste Elektronenstrahlquelle gemäß den Ansprüchen 1 bis 4, zur thermischen, kontrollierten, großflächigen, zerstörungsfreien Umwandlung einer Oberflächenschicht, mittels eines oder mehrerer Elektronenstrahlpulse, zur Beeinflussung der Materialeigenschaften bis zu einer Tiefe von 5 bis 50 μm.

6. Verwendung nach Anspruch 5, dadurch gekennzeichnet, daß die Pulsform der Stoßleistungsanlage nach Anspruch 1 auch Stufen enthalten kann mit dem Ziel gewünschte Temperaturprofile in der behandelten Oberflächenschicht zu erhalten.

**Claims**

1. Pulsed electron beam source according to the vacuum diode principle, comprising a vacuum diode with a multipoint emission cathode having a plurality of emission points (8), a control grid, a pulse generator, a magnetic compression unit formed from field coils, a drift chamber, a target chamber and a synchronisation unit, characterised in that the cathode is embedded in a shield grid electrode (6), the shield electrode (6) being connected to the cathode flange (2) via a resistor (9), and the resistor (9) being so dimensioned that the shield electrode (6) can float freely.

2. Pulsed electron beam source according to claim 1, characterised in that the shield electrode (6) is configured like a cup, bores being provided in the base thereof, through the entirety of which bores only the end of the cylindrical resistors (7), provided with the emission points (8) mounted thereon, protrudes in flush manner.

3. Pulsed electron beam source according to claims 1 and 2, characterised in that, at its open edge, the shield electrode (6) is inclined at an angle α, which is determined by the optimum radius of curvature of the multipoint emission cathode.

4. Pulsed electron beam source according to claims 1 to 3, characterised in that, at its open edge, the shield electrode (6) has a diameter which is greater by 2*F than at the closed edge, F being equal to the spacing d between the control grid and the emission points.

5. Use of the pulsed electron beam source according to claims 1 to 4, for the thermal, controlled, large-surface, non-destructive conversion of a surface layer, by means of one or more electron beam pulses, to influence the material properties up to a depth of between 5 and 50 μm.

6. Use according to claim 5, characterised in that the pulse shape of the surge-power system according to claim 1 may also include stages with the object of obtaining desired temperature profiles in the treated surface layer.

**Revendications**

1. Source de faisceau d'électrons, pulsée, fonctionnant selon le principe de la diode à vide et comprenant une diode à vide avec une cathode d'émission à point multiple et un grand nombre de points d'émission (8), une grille de commande, un générateur d'impulsions, une unité de compression magnétique formée de bobines de champ, une chambre de dérive, une chambre de cible et une unité de synchronisation,
caractérisée en ce que

- la cathode est intégrée dans une électrode-écran (6),
- l'électrode-écran (6) est reliée par une résistance (9) à la bride de cathode (2),
- la résistance (9) est dimensionnée pour que l'électrode-écran (6) puisse flotter librement.

2. Source de faisceaux d'électrons pulsée selon la revendication 1,
caractérisée en ce que
l'électrode-écran (6) est en forme de gobelet dont le fond comporte des perçages traversés à fleur dans leur intégrité par l'extrémité d'éléments résistants cylindriques (7) portant sur leur dessus des points d'émission (8).

3. Source de faisceaux selon l'une des revendications 1 et 2,
caractérisée en ce que
l'électrode-écran (6) est inclinée vers le bas au niveau de son bord ouvert d'angle (α) défini par le rayon de courbure optimum de la cathode d'émission multipoint.

4. Source de faisceaux selon l'une des revendications 1 à 3,
caractérisée en ce que
l'électrode formant écran (6) présente au niveau de son bord ouvert, un diamètre plus grand de 2*F que le bord fermé, F étant égal à la distance (d) entre la grille de commande et les points d'émission.

5. Application d'une source de faisceau d'électrons, pulsée selon les revendications 1 à 4, pour la conversion thermique, contrôlée, de grande surface, sans destruction d'une couche de surface à l'aide d'une ou plusieurs impulsions de faisceau d'électrons pour influencer les propriétés de la matière jusqu'à une profondeur de 5-50 μm.

6. Application selon la revendication 5,
caractérisée en ce que
la forme des impulsions de l'installation de puissance par à-coup selon la revendication 1 ou après l'échelonnement obtenu avec pour objectif des profils de température souhaités dans la couche de
surface traitée.